# EUROPEAN PATENT APPLICATION

(11) **EP 3 116 012 A1**
(43) Date of publication of application: **11.01.2017**
(21) Application number: 15175699.6
(22) Date of filing: 07.07.2015
(51) Int. Cl.: H01H 36/00, H03K 17/95

(54) **SAFETY SWITCH**

(71) Applicant: Kone Corporation, 00330 Helsinki (FI)
(72) Inventor: Aitamurto, Juha-Matti, 05800 Hyvinkää (FI); Kattainen, Ari, 05830 Hyvinkää (FI)
(74) Representative: Papula Oy

(57) **Abstract**

An elevator safety switch for detecting closure of two parts is described. The safety switch may be used for example in doors, windows and other covers. The safety switch has two parts so that the first part includes magnetically operable switches and the second part comprises permanent magnets. In the first part the magnetically operable switches are connected in series. The first part further comprises a resistor for each of the magnetically operable switches and the resistor is connected in parallel with the respective magnetically operable switch. These two parts are arranged so that they meet when they are in use. Switch parts attached to a door meet each other when the door is closed. When these two parts meet each other the magnets are configured to change the state of the magnetically operable switches. If only one magnetically operable switch changes state it can be determined that the other magnetically operable switch may be broken.

## Description

### FIELD OF THE INVENTION

The invention relates to switches and in particular to safety switches e.g. for a door, window, cover or balustrade.

### BACKGROUND OF THE INVENTION

Safety switches can be used when indication of the proximity of two parts or lack thereof is necessary. One typical example is a door switch that is used to detect if the door is closed or not. In some applications it is important for the sake of safety to detect that a door is closed. For example, an elevator car is not safe if the doors are not properly closed.

Typically these safety switches are electromechanical so that typically mechanical parts connect with each other when the doors are closed. The mechanical parts are provided with electricity conductors so that when the door is closed the electricity is connected and the closure of the door can be detected. Similar switches may be used also in different applications where it is necessary to detect if something is closed or connected together.

The problem with mechanical parts is that they tend to wear and are prone to impurity. Thus, sometimes the mechanical parts cause problems because the mechanical parts do not meet anymore and thus, no electrical connection is formed. Sometimes the connection is disturbed by the dirt. These problems naturally cause additional cost to the maintenance.

### SUMMARY

A safety switch for detecting proximity of two parts is described. The safety switch may be used for example in doors, windows and other covers. The safety switch has two parts so that the first part includes magnetically operable switches and the second part comprises permanent magnets. In the first part the magnetically operable switches are connected in series. The first part further comprises a resistor for each of the magnetically operable switches and the resistor is connected in parallel with the respective magnetically operable switch. Switch parts attached to a door meet each other when the door is closed. When these two parts meet each other the magnets are configured to change the state of the magnetically operable switches. If only one magnetically operable switch changes state it can be determined that the other magnetically operable switch may be broken.

In an embodiment the invention is implemented as a safety switch comprising a first part, wherein the first part further comprises at least two magnetically operable switches connected in series and at least two resistors, wherein a resistor is configured for each of the magnetically operable switch connected in parallel with regard to the respective magnetically operable switch. The safety switch further comprises a second part, wherein the second part further comprises at least two permanent magnets. In a further embodiment the first part and the second part are configured to meet when the safety switch is in use. In a further embodiment the permanent magnets are configured to change the state of the magnetically operable switches when the first part and the second part meet in use. In a further embodiment magnetically operable switches are normally open reed switches. In a further embodiment the safety switch further comprises at least two connectors. In a further embodiment the safety switch is a door safety switch.

In a further embodiment the safety switch described above is used in a door, window or cover. In a further embodiment the first part of the safety switch is attached to the first part of the door, window or similar and the second part of the safety switch is attached to the second part of the door, window or similar so that the first part and second part of the safety switch meet when the door is closed. In a further embodiment a door as discussed above is used in an elevator car.

The safety switch described above includes a plurality of benefits over conventional art. A benefit of the safety switch is that is protected against dirt, dust, moisture and environmental gases because of the enveloping of the magnetically operable switches. Furthermore, the safety switch may be installed behind a protective cover so that it is protected also from all mechanical connections. A further benefit of the safety switch is that the resistance of the safety switch is low under normal operation when the safety switch is not broken. A further benefit of the safety switch is that it is still operable if one of the magnetically operable switches is broken. A further benefit of the safety switch is that it is possible to detect remotely without manual inspection that one of the magnetically operable switches is broken. A benefit of the safety switch is that the maintenance call can be made without disturbing the operation of the elevator or other system to which the safety switch is attached to. A further benefit of the invention is that because of the closed structure there is no risk of electric shock to a maintenance person. A further benefit of the safety switch is that the door, window or similar cover is possible to design with larger tolerances as there is no need for precise mechanical compatibility of two parts of the safety switch. It is enough that they meet close enough for the magnet to change the state of the magnetically operable switch. A further benefit of the safety switch is that the components used in the safety switch have generally very long life. Thus, it is possible that the safety switch needs not be changed during the lifetime of the door, window or similar. A further benefit of the safety switch is that it is completely maintenance free when operating normally.

A further benefit of the described switch is that it is possible to manufacture so that it is of same size and shape and include similar connector as conventional mechanical switches. Thus, the when conventional switches break they can be replaced by new switches.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:

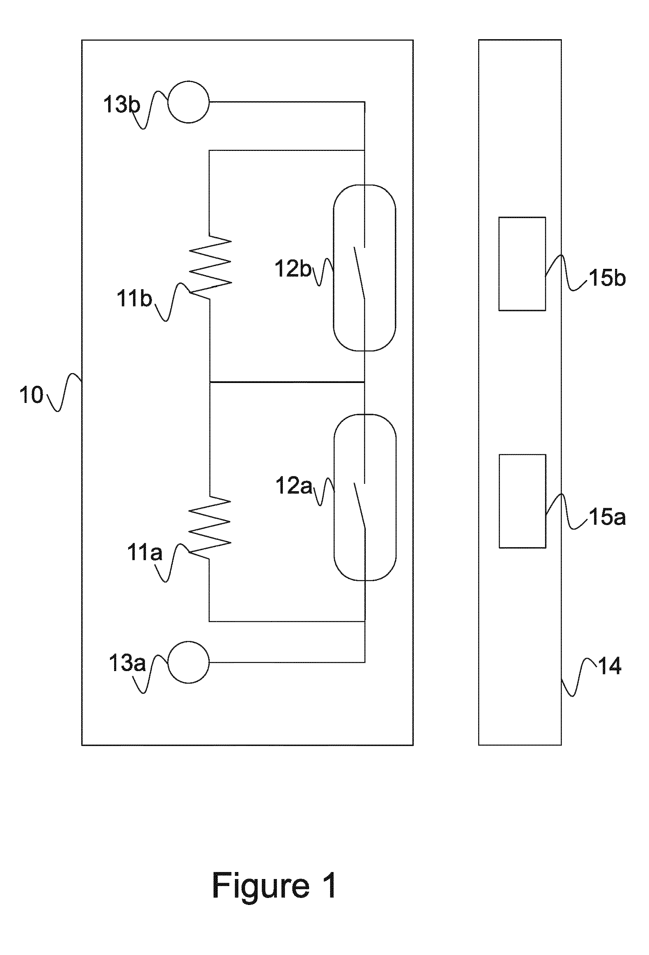

**Fig. 1** is a block diagram of an example embodiment of the present invention.

### DETAILED DESCRIPTION OF THE INVENTION

Reference will now be made in detail to the embodiments of the present invention, examples of which are illustrated in the accompanying drawings.

In figure 1 a switch is illustrated. The safety switch comprises a first part 10 and a second part 14. When the switch is used these parts are provided as counterparts. For example, when installed on a sliding elevator car door, the first part 10 may be installed to the door part on the left side and the second part 14 on the right part so that these two parts are in close proximity of each other when the doors are closed. Close proximity does not mean a direct contact and will be explained later.

The first part 10 comprises two resistors 11a and 11b, two magnetic switches 12a and 12b and connectors 13a and 13b for coupling to e.g. elevator safety circuit. The second part 14 comprises permanent magnets 15a and 15b. These permanent magnets 15a and 15b can also be separate pieces that are mounted to the door.

Switches 12a are 12b are switches commonly called as reed switches. The switch opens and closes according to the magnetic field in the vicinity. According to the preferred embodiment of the invention the switches 12a and 12b are such that they are open in normal condition. When magnets, such as permanent magnets 15a and 15b arrive close enough, the switches will close. The circuit of figure 1 is such that when both of the switches are closed the electricity runs through switches. Switches are installed in series so that both switches have a parallel resistor 11a and 11b. If the switch is open the electricity runs through respective resistor. Thus, an open switch is bypassed by the resistor. If we assume that both of resistors are 20kΩ, then when both switches are closed the resistance of the whole circuit is very small, when one of the switches is open and another closed, it is around 20kΩ and when both of the switches are open then the resistance is around 40kΩ.

The first part 10 comprises connectors 13a and 13b that may be used for measuring the resistance across the circuit. Based on the information received from the switch and from other systems it may be determined if the door is open for a purpose or because of a fault. For example, the first part 10 may be connected to a measurement device that provides the measurement result to a system controlling the door. Then, from the measurement results it can be determined if the door is open. Furthermore, the external system knows if the door should be open. For example, if the door has been just opened or a loading switch has been triggered and the door doesn't close, there is no need to react. However, if the system does not know any reason for the door being open, an alarm may be launched and sent to the maintenance person. Now, when the measurement result shows that only one switch 12a or 12b is closed and the other is open, an information message may be sent to a maintenance person. The maintenance person knows that the door is safe and operable when one of the switches is working and a maintenance visit can be scheduled when it is most convenient.

In an embodiment a door comprising a switch according to the description above is used in an elevator car. In this embodiment the door is typically a sliding door such that the door has a left part and right part. Thus, the first part 10 of the switch may be attached to the left part and the second part of the switch 14 may be attached to the right part. The parts should be attached so that they meet when the doors are closed. The first part 10 and second part 14 may be arranged such that they do not have mechanical contact but are, for example, behind respective protective covers. The attachment must be such that magnets are powerful enough to close the switches 12a and 12b when operating normally. Thus, by providing powerful magnets the distance between the first part 10 and second part 14 may be longer.

As mentioned above the safety switch may be installed to an elevator door or other elevator component that is connected to the elevator security circuit. This circuit is used for monitoring the safety of an elevator by detecting possible faults in the elevator. In case of fault the information derived from the safety circuit. The circuit may comprise a plurality of safety switches and/or sensors and is not limited to door security discussed above. However, the safety circuit typically comprises door safety switches. The safety switch described above is fully compatible with conventional safety circuits and replacing conventional safety switches by safety switches discussed above does not require any further modifications physical components. However, depending on the case, there may be a need for changing the controller software controlling the safety circuit.

The safety switch described above is easy to manufacture in different shapes and sizes. Furthermore, it can be manufactured from a plurality of different materials. Thus, it is possible to manufacture safety switches that are fully compatible with the space and connector requirements of existing applications. For example, the switch may be encapsulated in a protective material like resin or epoxy. These materials will provide very good protective properties and can easily be manufactured in different shapes and sizes. Furthermore, it is noted that the safety switch does not need to be exactly of same shape because there is no need for mechanical connection. In other words, it is enough that the shape and size are compatible with the space to which the safety switch is installed.

Even if in the above description magnets were used for closing switches, it is possible to use switches that are normally closed and a magnet is used to open them. Furthermore, even if the above description discusses only one switch comprising two parts attached to a one door, it is possible that a safety door comprises more than one door element that needs to be monitored. In that case, it is possible to connect a plurality of safety switches of figure 1 in series. When the doors are operating correctly and the safety switches are not broken the resistance measured corresponds with an even number of resistors. When the measurement result indicates a resistance corresponding with an odd number of resistors it can be determined that in one of the safety switches one magnetic switch is open and one closed. This situation indicates a possible fault. The switch described above may be used also in other applications than doors. For example, it is possible to use a similar switch in windows, covers and other objects where it needs to be determined reliably that two parts must be in close proximity to each other.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A safety switch comprising:
a first part (10), wherein the first part further comprises:
at least two magnetically operable switches (12a, 12b) connected in series; and
at least two resistors, wherein a resistor is configured for each of the magnetically operable switch connected in parallel with regard to the respective magnetically operable switch; and
a second part (14), wherein the second part further comprises at least two permanent magnets (15a, 15b) .

2. A safety switch according to claim 1, wherein said permanent magnets (15a, 15b) are configured to change the state of the magnetically operable switches when said first part (10) and said second part (14) are brought into close proximity.

3. A safety switch according to claim 1 or 2, wherein said magnetically operable switches (12a, 12b) are normally open reed switches.

4. A safety switch according to any of preceding claims, wherein said safety switch further comprises at least two connectors (13a, 13b).

5. A safety switch according to any of preceding claims, wherein said is a door safety switch for an elevator door.

6. A safety switch according to any of preceding claims, wherein at least one part of said safety switch is encapsulated in a protective material.

7. A safety switch according to claim 6, wherein said protective material is resin or epoxy.

8. A door comprising a safety switch according to any of preceding claims 1 - 7.

9. A door according to claim 8, wherein said first part (10) of the safety switch is attached to a first part of the door and said second part of the safety switch is attached to a second part of the door so that the first part (10) and second part (14) of the safety switch are brought into close proximity when the door is closed.

10. A door according to claim 9, wherein one said first part and second part of the door is a door leaf and the other of said first part and second part of the door is door frame.

11. A door according to claim 9, wherein said door is a sliding door comprising two parts.

12. An elevator- comprising a safety circuit comprising a safety switch according to any of preceding claims 1 - 7.
